# EUROPÄISCHE PATENTSCHRIFT

(11) **EP 0 831 332 B1**
(45) Veröffentlichungstag und Bekanntmachung des Hinweises auf die Patenterteilung: **09.01.2008**
(21) Anmeldenummer: 97116187.2
(22) Anmeldetag: 17.09.1997
(51) Int. Cl.: G01R 1/073

(54) **Adapter zum Prüfen von elektrischen Leiterplatten**
Adapter for testing electric circuit boards
Adaptateur de test des cartes de circuit électriques

(30) Priorität: 18.09.1996 DE 29616272 U
(43) Veröffentlichungstag der Anmeldung: 25.03.1998
(73) Patentinhaber: atg Luther & Maelzer GmbH, 97877 Wertheim/Reicholzheim (DE)
(72) Erfinder: Weiss, Stefan, 97877 Wertheim (DE); Prokopp, Manfred, 97877 Wertheim-Reicholzheim (DE); Schneider, Werner, 97900 Külsheim-Steinbach (DE); Geier, Rudi, 97900 Külsheim-Hundheim (DE)
(74) Vertreter: Ganahl, Bernhard

(56) Entgegenhaltungen:
- DE-A- 4 342 654
- DE-A- 4 417 811
- JP-A- 4 038 480
- JP-A- 63 124 969
- US-A- 5 575 076

## Beschreibung

Die Erfindung betrifft einen Adapter zum Prüfen von elektrischen Leiterplatten nach dem Oberbegriff des Anspruchs 1.

Adapter zum Prüfen von elektrischen Leiterplatten werden in Prüfvorrichtungen eingesetzt, die nach Art einer Presse eine zu prüfende Leiterplatte, den Prüfling, zwischen zwei plattenförmige Elemente einklemmen, wobei zur Kontaktierung der Prüfpunkte ein Adapter vorgesehen ist, der eine Vielzahl von Prüfnadeln aufweist, die im Muster der Prüfpunkte angeordnet sind. Der Prüfling wird gegen den Adapter gedrückt, so daß die Prüfpunkte am Prüfling von jeweils einer Prüfnadel kontaktiert werden.

Herstellungsbedingt weisen die Prüflinge bzw. deren Prüfmuster häufig einen Verzug auf, so daß durch einfaches Einsetzen des Prüflings in die Prüfvorrichtung in eine vorab festgelegte Position oft nicht der gewünschte Kontakt zwischen den Prüfpunkten und den Prüfnadeln hergestellt wird.

Es sind daher Prüfvorrichtungen bekannt, in welchen eine relative Verschiebung und Justierung des Adapters, der Prüfnadeln und/oder des Prüflings erfolgen kann. In der DE 44 17 811 A1 ist ein Adapter beschrieben und dargestellt (Fig. 7 in DE 44 17 811 A1), der eine verstellbare Justierplatte aufweist, die mittels eines Verstellantriebes zu einem Prüfling ausgerichtet werden kann. Dieser Adapter ist als sogenannter Mehrplattenadapter ausgebildet, bestehend aus mehreren, drei oder fünf, jeweils in einem Abstand parallel zueinander angeordneter Führungsplatten, die durch am Umfang angeordnete Distanzteile voneinander beabstandet befestigt sind. Die Führungsplatten werden von Prüfnadeln durchgriffen. Die Justierplatte liegt auf der prüflingsseitig angeordneten Führungsplatte auf und ist zusammen mit dieser verstellbar. Der Verstellantrieb weist eine Gewindespindel auf, die nach außen geführt ist und mit einer Mikrometerschraube versehen ist, so daß der Adapter manuell justiert werden kann. Anstatt einer Mikrometerschraube kann auch ein Motor vorgesehen werden, der eine maschinelle Verstellung erlaubt.

Aus der DE 43 42 654 A1 ist eine Prüfvorrichtung bekannt, bei der die zu prüfende Leiterplatte auf der Prüfvorichtung durch Verschieben mittels Antriebsmotoren justiert wird (Fig. 16, 17, 19). Jeder dieser Antriebsmotoren ist in einem separaten handgehaltenen Gehäuse enthalten, das zur lösbaren Verbindung mit dem Gehäuse vorgesehen ist. Diese Prüfvorrichtungen weisen keinen separat ausgebildeten Adapter auf und die gesamte Prüfvorrichtung ist speziell für diese Justiereinrichtung ausgebildet

Aus JP 4-38480 A ist ein automatischer Adapter zum insbesondere beidseitigem Prüfen von elektrischen Leiterplatten bekannt, der einen Adapterkörper und eine Anzahl von den Adapterkörper durchgreifenden Prüfnadeln aufweist, wobei mittels einer Mikroverstelleinrichtung die Leiterplatte bezüglich der Prüfnadeln durch eine relative Verschiebung zwischen der Leiterplatte und den Prüfnadeln feinjustiert werden kann, wobei die Verstelleinrichtung eine Nadelführungsplatte aufweist, in der die mit den Prüfpunkten zu kontaktierenden Enden der Prüfnadeln in Führungsbohrungen gelagert sind, die im Muster der zu prüfenden Prüfpunkte der Leiterplatte angeordnet sind. Zum Bewegen der Verstelleinrichtung ist ein außen am Adapter befestigter Schraubenantrieb vorgesehen.

Aus JP 63-124969 A ist ein automatischer Adapter zum Prüfen von elektrischen Leiterplatten bekannt, bei dem zum Verstellen der relativen Position zwischen Leiterplatte und den Prüfnadeln ebenfalls ein außenliegender Schraubenantrieb verwendet wird.

Aus der DE 44 45 642 A1 geht ein piezoelektrisches Antriebs- bzw. Verstellelement hervor. Dieses Verstellelement weißt zwei piezoelektrische Stapel auf, die möglichst dicht nebeneinander parallel angeordnet sind. Die Stapel sind jeweils mit ihren ersten Stapelstirnflächen über eine verkippbare Anbindung an einen Schenkel abgestützt und die gegenüberliegenden zweiten Stapelstirnflächen sind mittels einer biegesteifen gemeinsamen Traverse miteinander starr verbunden. Mit diesem Verstellelement kann sowohl eine Verkippung als auch ein Hub ausgeführt werden.

Aufgabe der Erfindung ist es, einen Adapter zu schaffen, der einfach aufgebaut ist, eine exakte Justierung zwischen den Prüfnadeln und den Prüfpunkten des Prüflings ermöglicht und an beliebigen Prüfvorrichtungen herkömmlicher Bauart verwendbar ist.

Die Aufgabe wird durch einen Adapter mit den Merkmalen des Anspruchs 1 gelöst, sowie durch Prüfvorrichtungen nach den Ansprüchen 10 bzw. 12. Vorteilhafte Ausgestaltungen sind in den Unteransprüchen angegeben.

Es wird eine Verstelleinrichtung zum Justieren der Prüfnadeln auf an der Leiterplatte vorgesehenen Prüfpunkten durch eine relative Verschiebung zwischen der Leiterplatte und den Prüfnadeln vollständig im Adapter angeordnet. Da die Verstelleinrichtung in den Adapter integriert ist, kann der Adapter in seinen Außenabmessungen genauso wie herkömmliche Adapter gestaltet werden, so daß ohne eine mechanische Umrüstung ein erfindungsgemäßer Adapter in einer bestehenden Prüfvorrichtung verwendet werden kann, wobei eine exakte Justierung zwischen den Prüfnadeln und den Prüfpunkten des Prüflings ermöglicht wird.

Die Erfindung wird anhand der in den Zeichnungen dargestellten Ausführungsbeispielen näher erläutert. Es zeigen:
- Fig. 1: schematisch vereinfacht einen Bereich eines Adapters im Querschnitt,
- Fig. 2: schematisch vereinfacht einen erfindungsgemäßen Adapter in einer Draufsicht,
- Fig. 3a bis 3c: jeweils eine Lochmatrix des in Fig. 2 gezeigten Adapters,
- Fig. 4: eine Piezoverstelleinheit in einer Draufsicht,
- Fig. 5: schematisch vereinfacht eine Prüfvorrichtung mit zwei miteinander gekoppelten Pin-Translator-Adaptern zum zweiseitigen Prüfen einer Leiterplatte,
- Fig. 6: schematisch vereinfacht eine Prüfvorrichtung mit zwei miteinander gekoppelten Starrnadel-Adaptern zum zweiseitigen Prüfen einer Leiterplatte,
- Fig. 7: eine Draufsicht auf einen Adapter.

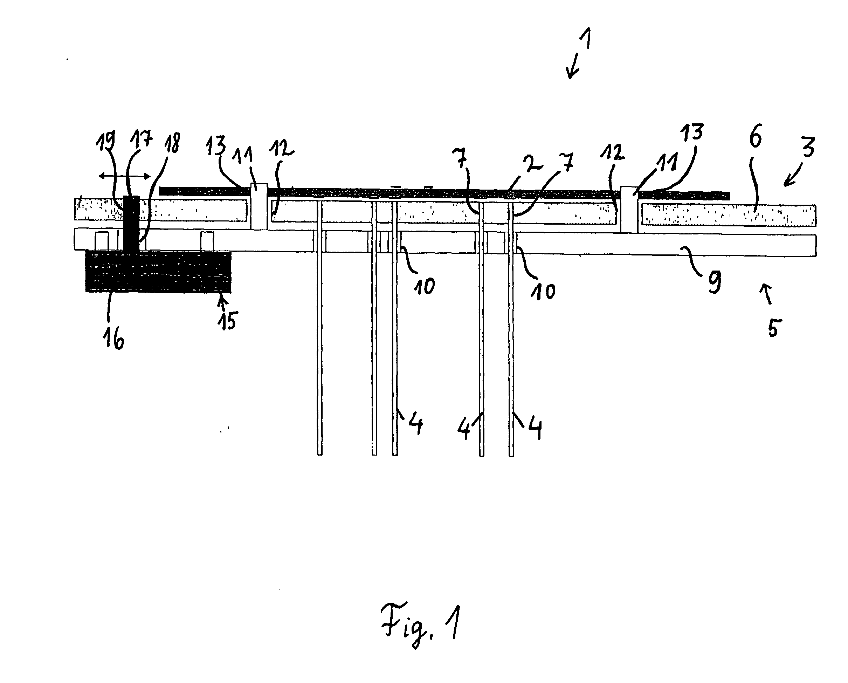

Der grundsätzliche Aufbau eines Adapters wird nachfolgend anhand von Fig. 1 erläutert. Dieser Adapter 1 zum Prüfen von elektrischen Leiterplatten 2 weist in an sich bekannter Weise einen Adapterkörper 3 auf, in dem eine Anzahl den Adapterkörper 3 durchgreifende Prüfnadeln 4 angeordnet sind. Ein solcher Adapterkörper ist üblicherweise aus mehreren übereinander mit und ohne Abstand angeordneten Platten 5 ausgebildet.

Eine der Platten 5, vorzugsweise diejenige, die den Adapter 1 leiterplattenseitig begrenzt, ist als Nadelführungsplatte 6 ausgebildet. Die Nadelführungsplatte 6 weist im Muster der zu prüfenden Kontaktpunkte vertikale Führungsbohrungen 7 auf, in welchen Endbereiche der Prüfnadeln 4 formschlüssig geführt sind. Diese Enden der Prüfnadeln sollen mit den Prüfpunkten einer Leiterplatte 2 in elektrischen Kontakt gebracht werden. Eine Leiterplattenpositioniereinrichtung ist vorgesehen, um die zu prüfende Leiterplatte 2 relativ zu der Nadelführungsplatte 6 in einer veränderlichen Position anzuordnen. Als Leiterplattenpositioniereinrichtung ist eine Positionierplatte 9 vorgesehen, die benachbart zu der Nadelführungsplatte 6 auf der von der Leiterplatte 2 abgewandten Seite angeordnet ist.

In die Positionierplatte 9 sind wiederum im Muster der Prüfpunkte vertikale Bohrungen 10 eingebracht, die die Prüfnadeln 4 mit einem Spiel umfassen, so daß die beiden Platten 6, 9 gegeneinander verschoben werden können. An der Positionierplatte 9 sind vorzugsweise zwei Leiterplattenaufnahmestifte 11 befestigt, die sich durch in die Nadelführungsplatte 6 eingebrachte Bohrungen 12 hindurch erstrecken, wobei sie an der Nadelführungsplatte 6 überstehen. Die Bohrungen 12 umfassen die Leiterplattenaufnahmestifte 11 mit einem Spiel, so daß die beiden Platten 6, 9 im Bereich dieses Spieles gegenseitig verschoben werden können.

Die Leiterplattenaufnahmestifte 11 können in entsprechende Paßbohrungen 13 einer Leiterplatte 2 eingreifen, so daß die Lage der Leiterplatte 2 bezüglich der Positionierplatte 9 fixiert ist. Somit kann durch eine relative Verschiebung der Nadelführungsplatte 6 zu der Positionierplatte 9 eine Verschiebung einer Leiterplatte 2 auf der Nadelführungsplatte 6 bewirkt und die Prüfpunkte der Leiterplatte 2 auf die Prüfnadeln 4 des Adapters 1 ausgerichtet werden.

Zum gegenseitigen Verschieben der Platten 6, 9 ist eine Verstelleinrichtung 15 vorgesehen, die in den Adapterkörper integriert ist. Die Verstelleinrichtung ist bspw. aus einem elektrisch betätigbaren Aktuator 16 ausgebildet, der mit beiden Platten 6, 9 in Eingriff steht. Der Aktuator 16 ist vorzugsweise an der Positionierplatte 9 an der von der Nadelführungsplatte 6 abgewandten Seite befestigt. Am Aktuator 16 ist ein Verstellstift 17 angeordnet, der zumindest in eine Richtung, vorzugsweise jedoch in zwei Richtungen und zwar in der Ebene der Platten 6, 9 verschiebbar ausgebildet ist. Der Verstellstift 17 erstreckt sich durch eine Bohrung 18 durch die Positionierplatte 9 hindurch und weist einen an der Positionierplatte 9 überstehenden Bereich auf, mit dem er formschlüssig in eine Bohrung 19 in der Nadelführungsplatte 6 eingreift. Die Bohrung 18 in der Positionierplatte 9 wird vom Verstellstift 17 mit Spiel durchgriffen, so daß der Verstellstift 17 in einem zum Justieren ausreichenden Maße verschoben werden kann.

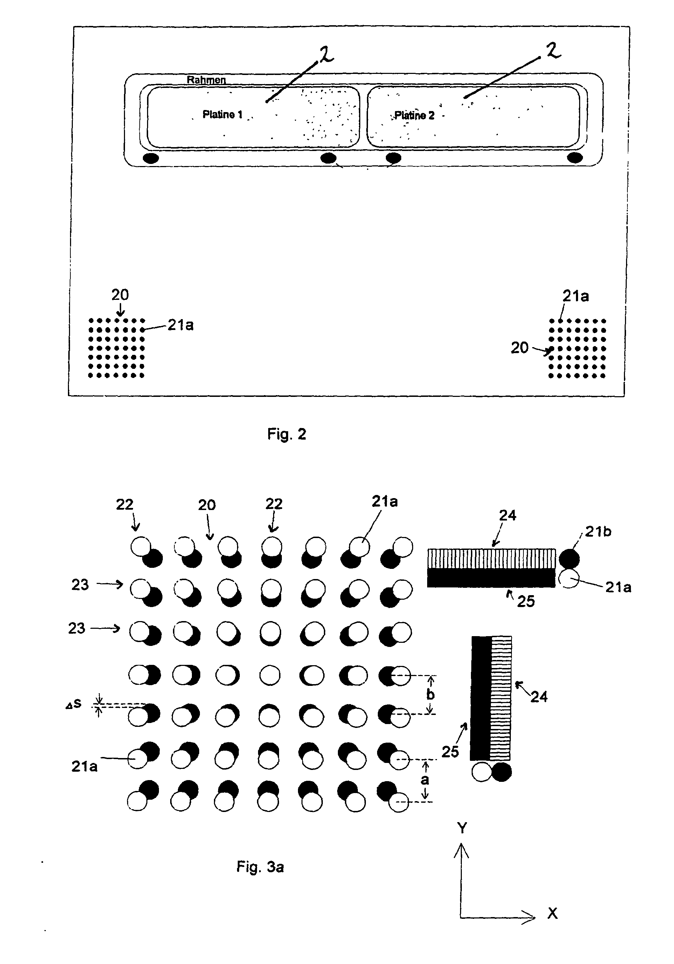

Eine sehr einfache Ausführungsform einer erfindungsgemäßen Verstelleinrichtung ist in den Fig. 2 bis 3c dargestellt. Hierbei ist in der Positionierplatte 9 und in der Nadelführungsplatte 6 in einem übereinander angeordneten Bereich jeweils eine Lochmatrix 20 ausgebildet. Im dargestellten Ausführungsbeispiel weist jede Lochmatrix 7x7 Löcher 21a, 21b auf, die in einem Quadrat mit jeweils konstantem Lochabstand a bzw. b zwischen den benachbarten Löchern 21a, 21b angeordnet sind. Die Löcher 21a, 21b sind in jeweils sieben Spalten 22 und sieben Reihen 23 angeordnet, wobei sich die Spalten in Y-Richtung und die Reihen in X-Richtung erstreken.

Die Löcher 21a, 21b der beiden Matrizen sind jeweils mit unterschiedlichem Rastermaß angeordnet. Der Lochabstand a der Löcher 21a (weiß in Fig. 3a bis 3c) der Nadelführungsplatte 6 ist z.B. um Δs größer oder kleiner als der Lochabstand b der Löcher 21b (schwarz in Fig. 3a bis 3c) der Positionierplatte 9. In den beiden Matrizen 20 sind jeweils die Löcher 21a, 21b gleicher Reihe 23 und gleicher Spalte 22 einander paarweise zugeordnet. Durch Einstecken eines Stiftes (nicht dargestellt) in ein solches Lochpaar werden die beiden Löcher 21a, 21b des Lochpaares zueinander fluchtend ausgerichtet, wodurch die Positionierplatte 9 und die Nadelführungsplatte 6 entsprechend relativ zueinander verschoben werden.

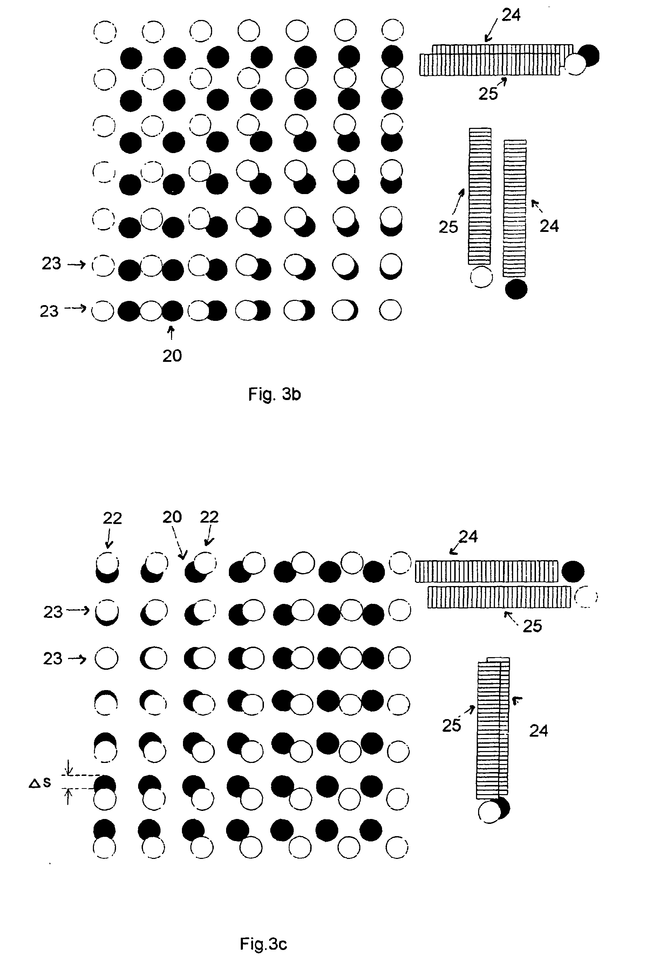

In einer sogenannten Null-Stellung (Fig. 3a) wird das zentrale Lochpaar mit den Löchern 21a, 21b der vierten Reihe und der vierten Spalte zueinander fluchtend ausgerichtet, so daß die beiden Matrizen zueinander zentrisch ausgerichtet sind. Die Null-Stellung entspricht der Ausrichtung der Prüfnadeln 4 für eine ideale Leiterplatte 2 ohne Verzug. Die Löcher 21a, 21b eines Lochpaares, das von dem zentralen Lochpaar um n Spalten und k Reihen entfernt ist, weisen einen Versatz von n·Δs in X-Richtung und Δs in Y-Richtung auf. Das bedeutet, daß der Versatz umso größer ist, je weiter die Lochpaare vom zentralen Lochpaar beabstandet sind. Wird somit ein anderes Lochpaar als das zentrale Lochpaar durch Einstecken eines Stiftes in Flucht gebracht, so werden die Platten 6, 9 um diesen Versatz verschoben. Werden z.B. die Löcher des Lochpaares der siebten Reihe und der siebten Spalte (Fig. 3b) zueinander ausgerichtet, so wird die Positionierplatte 9 gegenüber der Nadelführungsplatte 6 um 3. Δs in X-Richtung nach rechts und um 3. Δs in Y-Richtung nach unten verschoben, wie es an den seitlich dargestellten Testmarkierungen 24 für die Positionierplatte 9 bzw. den Testmarkierungen 25 für die Nadelführungsplatte 6 erkennbar ist.

In Fig. 3c sind die Löcher 21a, 21b des Lochpaares der ersten Spalte und der dritten Reihe in Flucht gebracht, so daß die Positionierplatte 9 gegenüber der Nadelführungsplatte 6 um 3. Δs in X-Richtung nach links und um 1·Δs in Y-Richtung nach oben verschoben ist.

Mit den erfindungsgemäßen Lochmatrizen 20 läßt sich somit ein Versatz an einer Leiterplatte 2 einfach und sehr präzise durch Stecken eines Stiftes in eines der Lochpaare ausgleichen. Vorzugsweise weist ein Adapter zwei Verstelleinrichtungen 15 mit derartigen Lochmatrizen 20 auf, so daß die relative Position der beiden Platten 6, 9 eindeutig festgelegt ist.

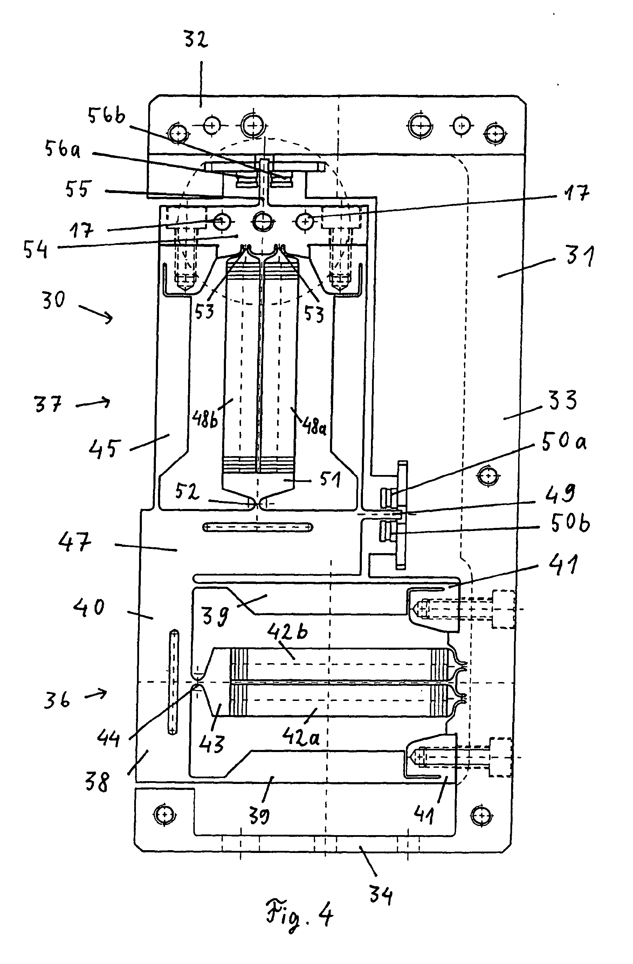

Es kann auch eine Piezoverstelleinheit 30 (Fig. 4) in den Adapter 1 integriert werden, so daß die Justierung der Leiterplatte 2 bezüglich der Prüfnadeln 4 maschinell erfolgen kann.

Die Piezoverstelleinheit ist plattenförmig ausgebildet, mit einem im wesentlichen C-förmigen Tragrahmen 31. Der C-förmige Tragrahmen weist eine obere Querstrebe 32, eine seitliche Längsstrebe 33 und eine untere Querstrebe 34 auf. In den Tragrahmen 31 sind fünf Gewindebohrungen 35 eingebracht, mit welchen die Piezoverstelleinheit 30 an die Positionierplatte 9 geschraubt wird.

In dem C-förmigen Rahmen sind zwei zueinander senkrecht angeordnete Stellglieder 36, 37 angeordnet. Das Stellglied 36 ist benachbart zur unteren Querstrebe 34 ausgebildet und bildet in der Draufsicht einen U-förmigen Schwenkrahmen 38 mit zwei Schenkeln 39 und einem Basissteg 40. Die beiden Schenkel 39 sind parallel zu der unteren Querstrebe 34 ausgerichtet und mit ihren freien Enden 41 an der Längsstrebe 33 befestigt.

Zwischen den beiden Schenkeln 39 sind zwei parallel nebeneinander und parallel zu den Schenkeln 39 angeordnete Piezoelementstangen 42a, 42b vorgesehen, die sich zwischen der Längsstrebe 33 und dem Basissteg 40 erstrecken. Die Piezoelementstangen 42a, 42b sind schwenkelastisch an der Längsstrebe 33 und mittels eines Schwenkelements 43 am Basissteg 40 befestigt. Das Schwenkelement 43 ist ein sich über die gesamte Breite der beiden Piezoelementstangen 42a, 42b erstreckendes Bauteil, das mit dem Basissteg 40 mit einem sehr schmalen Anbindungssteg 44 einteilig verbunden ist, so daß hier eine elastische Engstelle ausgebildet ist. Die beiden Piezoelementstangen 42a, 42b werden im Betrieb mit einer entgegengesetzt gepolten Spannung beaufschlagt, so daß sich die Piezoelementstangen 42a, 42b entgegengesetzt strecken bzw. zusammenziehen. Da die Enden der Piezoelementstangen in unveränderlichen Abstand zueinander angeordnet sind, biegen sie sich durch und das Schwenkelement 43 und der Basissteg 40 werden in Fig. 4 aufwärts bzw. abwärts bewegt. Hierbei bilden die Schenkel 39 eine Art Parallellenker für den Basissteg, wobei die Schenkel 39 in der Draufsicht an den Enden verjüngt ausgebildet sind, um eine Elastizität in der Art eines Festkörpergelenkes vorzusehen.

Das zweite Stellglied 37 ist ähnlich zum ersten Stellglied 36 mit einem U-förmigen Schwenkrahmen 45 mit zwei Schenkeln 46 und einem Basissteg 47 und zwei Piezoelementstangen 48a, 48b ausgebildet. Der Basissteg 47 des zweiten Stellgliedes 37 ist einteilig an den Basissteg 40 des ersten Stellgliedes 36 angebunden, wobei die beiden Basisstege 40, 47 in einem rechten Winkel zueinander angeordnet sind, so daß sich der Basissteg 47 des zweiten Stellgliedes 37 parallel und benachbart zu einem der Schenkel des ersten Stellgliedes 36 bis zur Längsstrebe 33 des Tragrahmens 31 erstreckt. An den Basissteg 47 ist an der Längsstrebe 33 ein Meßstift 49 angebunden, der zwischen zwei induktiven Sensoren 50a, 50b aufgenommen ist, die als Wegaufnehmer dienen.

Die Piezoelementstangen 48a, 48b sind an dem Basissteg 47 wiederum mit einem Schwenkelement 51 befestigt, das mit einem in der Draufsicht sehr schmalen Anbindungssteg 52 an den Basissteg 47 einteilig angebunden ist. Die dem Basissteg gegenüberliegenden Enden der Piezoelementstangen sind mittels dünner Anbindungsstege 53 schwenkelastisch an einem Bügel 54 befestigt. Der Bügel 54 erstreckt sich zwischen den beiden Enden der Schenkel 46 des U-förmigen Schwenkrahmens 45 und ist an diesen befestigt, so daß der U-förmige Schwenkrahmen 45 zu einem Rechteck abgeschlossen ist.

An dem Bügel 54 ist mittig, den Piezostangen 48a, 48b gegenüberliegend, ein weiterer Meßstift 55 angebunden, der senkrecht vom Bügel absteht und sich in Richtung zur oberen Querstrebe 32 des Tragrahmens 31 erstreckt. Das freie Ende des Meßstiftes 55 ist zwischen zwei induktiven Sensoren 56a, 56b aufgenommen, so daß eine Bewegung des Meßstifts in seiner Längsrichtung durch die Meßbacken 56a, 56b feststellbar ist. An dem Bügel 54 sind zwei nach oben vorstehende Verstellstifte 17 befestigt, die in der oben beschriebenen Art und Weise die Nadelführungsplatte 6 mit Spiel durchgreifen und in die Positionierplatte 9 spielfrei eingreifen.

Die beiden Piezoelementstangen 48a, 48b werden im Betrieb mit einer entgegengesetzt gepolten Spannung beaufschlagt, so daß sich die Piezoelementstangen 48a, 48b aufgrund der entgegengesetzten Längenkontraktion bzw. Längenausdehnung durchbiegen und den Bügel 54 gegenüber dem Basissteg 47 verschieben.

Die Schenkel 46 des U-förmigen Schwenkrahmens dienen als Parallellenker, so daß der Bügel 54 bezüglich des Basisstegs 47 parallel verschoben wird.

Durch das Vorsehen der beiden zueinander senkrecht angeordneten Stellglieder 36, 37 können die Verstellstifte 17 in der Ebene der Piezoverstelleinheit in zwei zueinander senkrechten Richtungen verstellt werden, wobei die Verstellstifte 17 bezüglich des Tragrahmens 31 verschoben werden. Der Tragrahmen 31 ist an der Positionierplatte 9 befestigt, und die Verstellstifte 17 stehen mit der Nadelführungsplatte 6 in Eingriff, so daß die beiden Platten beim Betätigen der Stellglieder gegeneinander verschoben werden.

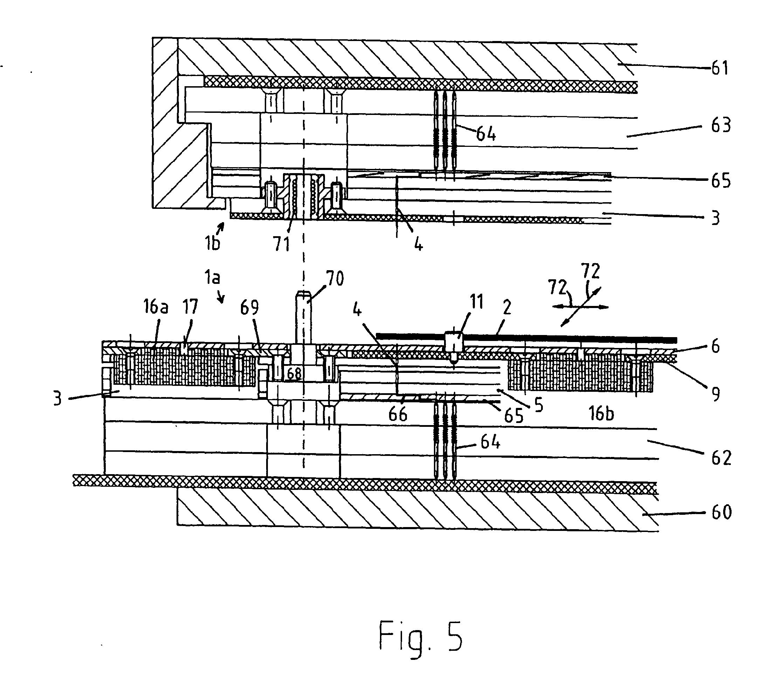

In Fig. 5 ist schematisch vereinfacht eine Prüfvorrichtung mit zwei miteinander gekoppelter Pin-Translator-Adaptern zum zweiseitigen Prüfen einer Leiterplatte 2 dargestellt.

Die Prüfvorrichtung weist zwei Druckplatten 60, 61 auf, die in der Art einer Presse zum Testen einer Leiterplatte 2 zusammengedrückt werden können. An den sich gegenüberliegenden Flächen der beiden Druckplatten 60, 61 ist in an sich bekannter Weise jeweils eine Vollrasterkassette 62, 63 befestigt. Eine solche Vollrasterkassette 62, 63 weist einen Kassettenkörper auf, in dem mehrere zueinander parallel angeordnete federnde Prüfstifte 64 gelagert sind. Diese Prüfstifte 64 sind in einem vorbestimmten, einheitlichen Prüfraster angeordnet. An die Vollrasterkassette 62, 63 schließt sich jeweils ein Translator 65 an, der mittels Leiterbahnen 66 das vorbestimmte, einheitliche Prüfraster in ein Prüffeld umsetzt, dessen Kontaktpunkte in der gleichen Anordnung wie die zu prüfenden Prüfpunkte der Leiterplatte 2 ausgerichtet sind.

An den Translator 65 schließt sich jeweils ein unterer und ein oberer Adapter 1a, 1b an, deren Nadeln 4 vertikal ausgerichtet im Adapterkörper 3 gelagert sind und die Kontaktpunkte des Translators 65 mit den Prüfpunkten der Leiterplatte 2 verbinden. Der an den Translator 65 angrenzende Bereich des Adapterkörpers 3 ist in an sich bekannter Weise aus mehreren Plattenlagen 5 ausgebildet.

In den unteren Adapter 1a ist ein Verankerungselement 68 integriert, das an eine horizontale Befestigungsplatte 69 befestigt ist, die sich in dem in Fig. 5 dargestellten Ausführungsbeispiel seitlich, weg von dem mittigen Bereich des Adapters 1a erstreckt.

An der Befestigungsplatte 69 ist ein erster Aktuator 16a mittels zweier Schrauben befestigt, der vorzugsweise aus der in Figur 4 gezeigten Piezoverstelleinheit ausgebildet ist. Die Verstellstifte 17 greifen in die Nadelführungsplatte 6 des unteren Adapters 1a ein, so daß die Nadelführungsplatte 6 gegenüber der Befestigungsplatte 69 durch den ersten Aktuator 16a verschoben werden kann. Die Nadelführungsplatte 6 und die Positionierplatte 9 sind über einen weiteren, den zweiten Aktuator 16b miteinander verbunden.

Wird der erste Aktuator 16a betätigt, so wird die Nadelführungsplatte 6 bezüglich der Befestigungsplatte 69, jedoch nicht gegenüber der Positionierplatte 9 verschoben. Der erste Aktuator 16a bewirkt somit im unteren Adapter 1a keine Veränderung der Ausrichtung zwischen den Prüfnadeln 4 und der Leiterplatte 2. Die Ausrichtung der Leiterplatte 2 gegenüber den Prüfnadeln 4 erfolgt durch den zweiten Aktuator 16b in der oben anhand von Fig. 1 beschriebenen Art und Weise.

An das Verankerungselement 68 ist ein senkrecht nach oben stehender Fangstift 70 befestigt. Der Fangstift 70 durchgreift die Nadelführungsplatte 6 mit Spiel, so daß die Nadelführungsplatte 6 eine ausreichende Bewegungsfreiheit aufweist, um den durch den ersten Aktuator 16a erzeugten Bewegungen zu folgen.

Im oberen Adapter 1b ist eine dem Fangstift 70 gegenüberliegende Kugelrollbuchse 71 angeordnet, in die der Fangstift 70 beim Zusammenfahren des oberen und des unteren Adapters 1a, 1b gleitend eingreift. In der Kugelrollbuchse 71 ist der Fangstift 70 exakt geführt. Durch den Fangstift 70 und die Kugelrollbuchse 71 werden die beiden Adapter 1a, 1b exakt zueinander ausgerichtet.

Wird der erste Aktuator 16a betätigt, so werden die Nadelführungsplatte 6 und die Positionierplatte 9 des unteren Adapters 1a gemeinsam verschoben. Mit der Positionierplatte 9 wird auch die mit den Leiterplattenaufnahmestiften 11 in Eingriff stehende Leiterplatte 2 mit verschoben, so daß eine Ausrichtung der auf der Oberseite der Leiterplatte befindlichen Prüfpunkten bzgl. der Prüfnadeln 4 des oberen Adapters 1b erfolgt. Der obere Adapter 1b ist durch den Fangstift 70 in seiner Position festgelegt, so daß der erste Aktuator 16a die Leiterplatte 2 bzgl. des feststehenden oberen Adapters bewegt, wie es durch die Pfeile 72 in Fig. 5 angedeutet ist.

Durch die im unteren Adapter 1a, 1b angeordneten Aktuatoren 16a, 16b kann somit eine Leiterplatte 2 sowohl gegenüber dem unteren als auch gegenüber dem oberen Adapter 1a, 1b ausgerichtet werden.

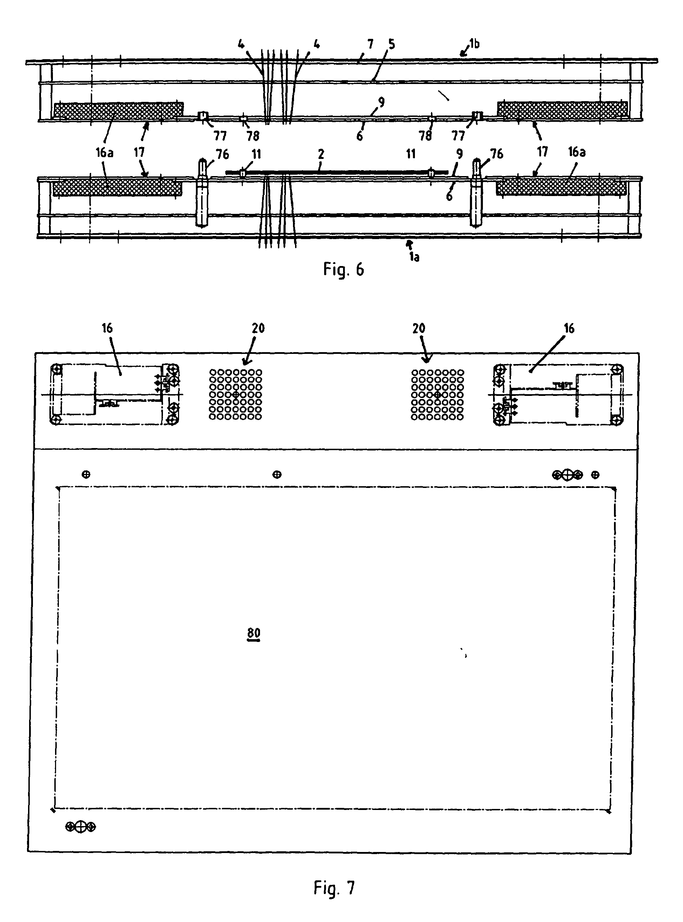

In Fig. 6 sind ein unterer und ein oberer Adapter 1a, 1b für eine weitere Prüfvorrichtung zum zweiseitigen Testen von Leiterplatten 2 dargestellt. Diese Adapter sind sogenannte Starrnadeladapter 1a, 1b, deren Prüfnadeln 4 im Adapterkörper 3 schräg angeordnet sind und so ohne Translator das Muster einer Vollrasterkassette unmittelbar auf die Prüfpunkte der Leiterplatte 2 umsetzen können.

Die Adapter 1a, 1b sind in an sich bekannter Art und Weise aus mehreren Führungsplatten 75 ausgebildet, wobei bspw. der untere Adapter 1a mit fest integrierten Fangstiften 76 versehen ist und der obere Adapter entsprechende Buchsen 77 aufweist, so daß beim Zusammenfahren der beiden Adapter 1a, 1b diese exakt zueinander ausgerichtet werden.

Der untere Adapter 1a weist zwei erste Aktuatoren 16a auf. Im Gegensatz zu den oben beschriebenen Ausführungsbeispielen ist die Nadelführungsplatte 6 auf der von der Leiterplatte 2 abgewandten Seite der Positionierplatte 9 angeordnet, so daß der untere Adapter 1a eine feste Einheit bildet, auf der die Positionierplatte 9 verschiebbar aufliegt und durch die ersten Aktuatoren 16a entsprechend verschoben werden kann, um eine durch Leiterplattenaufnahmestifte 11 geführte Leiterplatte 2 zu den in der Nadelführungsplatte 6 geführten Prüfnadeln 4 auszurichten.

Der obere Adapter 1b weist wiederum die Nadelführungsplatte 6 auf der zur Leiterplatte 2 zeigenden Seite der Positionierplatte 9 auf, um die Prüfnadeln 4 bzgl. der Leiterplatte 2 ausrichten zu können. Die an der Positionierplatte 9 des unteren Adapters 1a befestigten Leiterplattenaufnahmestifte 11 greifen in entsprechende Bohrungen 78 in der Nadelführungsplatte 6 und in der Positionierplatte 9 des oberen Adapters 1b mit Spiel ein, so daß die Leiterplatte 2 bezüglich des oberen Adapters 1a frei bewegt werden kann.

Diese unterschiedliche Ausbildung der beiden Adapter 1a, 1b hat den Vorteil, daß beim Ausrichten der Leiterplatte 2 gegenüber den Prüfnadeln des unteren Adapters 1a die Leiterplatte 2 auch gegenüber dem oberen Adapter 1b verschoben und oftmals auch in die korrekte Position gegenüber den Prüfnadeln 4 des oberen Adapters 1b gebracht wird. Die Justierung durch den oberen Adapter 1a kann somit oft entfallen oder auf eine kleine Nachjustierung beschränkt werden.

In Fig. 7 ist eine Draufsicht auf einen Adapter 1 gezeigt, wobei den größten Flächenbereich ein Prüffeld 80 einnimmt, in das entsprechend der Prüfpunkte der Leiterplatte 2 angeordnete Löcher (nicht dargestellt) zur Aufnahme der Prüfnadeln 4 gebohrt werden. An einem in Fig. 7 oben gezeigten Randbereich des Adapters 1 sind schematisch zwei Aktuatoren 16 eingezeichnet, die den in Fig. 4 gezeigten Aktuatoren entsprechen. Zusätzlich weist der Adapter 1 noch zwei der oben beschriebenen erfindungsgemäßen Lochmatrizen 20 auf, die zum Justieren und Kalibrieren der Aktuatoren 16 dienen. Vor dem endgültigen Befestigen der Aktuatoren werden die Nadelführungsplatte 6 und die Positionierplatte 9 durch Einstecken jeweils eines Stiftes in die Lochmatrizen zueinander ausgerichtet, wobei der Stift normalerweise in das mittige Lochpaar eingesteckt wird. Wenn Leiterplatten mit einem systematischen Versatz getestet werden, können die Aktuatoren 16 gelöst, die Platten 6, 9 um diesen systematischen Versatz mittels der Lochmatrizen verstellt und die Aktuatoren 16 wieder befestigt werden, so daß die Platten 6, 9 in der Ausgangsstellung der Aktuatoren bereits einen definierten Versatz aufweisen.

## Patentansprüche

1. Adapter zum Prüfen von elektrischen Leiterplatten, mit einem Adapterkörper (3) und einer Anzahl den Adapterkörper (3) durchgreifenden Prüfnadeln (4),
zwei Verstelleinrichtungen zum Justieren der Prüfnadeln (4) auf an der Leiterplatte (2) vorgesehenen Prüfpunkten durch eine relative Verschiebung zwischen der Leiterplatte (2) und den Prüfnadeln (4), wobei eine Verstelleinrichtung eine Nadelführungsplatte (6) aufweist, in der die mit den Prüfpunkten zu kontaktierenden Enden der Prüfnadeln in Führungsbohrungen (7) gelagert sind, die im Muster der zu prüfenden Prüfpunkte der Leiterplatte (2) angeordnet sind,
wobei die Verstelleinrichtungen eine Leiterplattenpositioniereinrichtung aufweisen, die eine zu prüfende Leiterplatte (2) in einer zum Adapter (1) festgelegten Position fixieren kann,
wobei die Nadelführungsplatte (6) und die Leiterplattenpositioniereinrichtung relativ zueinander verschiebbar angeordnet sind, so dass die mit den Prüfpunkten zu kontaktierenden Enden der Prüfnadeln (4) auf die Prüfpunkte ausgerichtet werden können, und
wobei die Verstelleinrichtungen innerhalb des Adapterkörpers (3) angeordnet sind,
und dass die Leiterplattenpositioniereinrichtung zumindest einen plattenförmigen Bereich aufweist, der mit der Nadelführungsplatte (6) überlappt, wobei in dem überlappenden Bereich sowohl in der Leiterplattenpositioniereinrichtung als auch in der Nadelführungsplatte (6) eine Anzahl von Löchern in einem vorbestimmten Muster eingebracht sind, wobei jeweils ein Loch (21b) der Leiterplattenpositioniereinrichtung einem Loch (21a) der Nadelführungsplatte (6) zugeordnet ist und die Löcher dieser einander zugeordneten Lochpaare bezüglich einer Nullstellung, die einer idealen Justierung für eine Leiterplatte (2) ohne Verzug entspricht, jeweils in unterschiedliche Richtung und/oder mit unterschiedlichem Abstand voneinander beabstandet sind, so dass durch Einstecken eines Stiftes die zwei Löcher (21a, 21b) eines Lochpaares zueinander fluchtend ausgerichtet und die Leiterplattenpositioniereinrichtung und die Nadelführungsplatte (6) entsprechend relativ zueinander verschoben sind.

2. Adapter nach Anspruch 1,
**dadurch gekennzeichnet,**
**daß** die Löcher (21a, 21b) jeweils in einer quadratischen Lochmatrix (20) angeordnet sind, wobei die Löcher (21a, 21b) jeweils einen konstanten Lochabstand (a, b) aufweisen, wobei sich der Lochabstand (a) der Löcher der Nadelführungsplatte (6) von dem Lochabstand (b) der Leiterplattenpositioniereinrichtung um Δs unterscheidet.

3. Adapter nach Anspruch 1 oder 2,
**dadurch gekennzeichnet, dass**
ein Aktuator (16) zum Verschieben der Leiterplattenpositioniereinrichtung und der Nadelführungsplatte (6) relativ zueinander vorgesehen ist, welcher eine Piezoverstelleinheit (30) ist, die zumindest ein Piezoelement zum gegenseitigen Verschieben der Leiterplattenpositioniereinrichtung und der Nadelführungsplatte (6) aufweist.

4. Adapter nach Anspruch 3, **dadurch gekennzeichnet,**
**daß** die Piezoverstelleinheit (30) zwei im rechten Winkel zueinander angeordnete Stellglieder aufweist.

5. Adapter nach Anspruch 4, **dadurch gekennzeichnet,**
**daß** die Stellglieder (36, 37) jeweils als Piezoelemente zwei Piezostangen (42a, 42b) aufweisen, die parallel zueinander angeordnet sind, und mit einer Spannung entgegengesetzter Polarität beaufschlagt werden, so daß sie sich beim Anlegen der Spannung seitlich bezüglich ihrer Längserstreckung verschwenken.

6. Adapter nach Anspruch 5, **dadurch gekennzeichnet,**
**daß** die Stellglieder (36, 37) jeweils einen U-förmigen Schwenkrahmen (38, 45) mit zwei Schenkeln (39, 46) und einem Basissteg (40, 47) aufweisen, wobei die Piezoelementstangen (42a, 42b, 48a, 48b) parallel zu und zwischen den Schenkeln (39, 46) angeordnet sind,
die Piezoelementstangen (42a, 42b, 48a, 48b) jeweils über ein Schwenkelement (43, 51) mit dem Basissteg (40, 47) verbunden sind, und
die freien Enden der Schenkel (39, 46) und der Piezoelementstangen (42a, 42b, 48a, 48b) mit einem Bereich eines Tragrahmens (31) oder einem Bügel (54) verbunden sind, die die U-förmigen Schwenkrahmen (38, 45) zu einem Rechteck abschließen, so daß bei Beaufschlagung der Piezoelementstangen (42a, 42b, 48a, 48b) mit einer Spannung die Basisstege (40, 47) parallel zu dem Bereich des Tragrahmens (31) oder des Bügels (54) in der Art eines Parallellenkers verschoben werden.

7. Adapter nach einem der vorhergehenden Ansprüche, **dadurch gekennzeichnet,**
**daß** die Leiterplattenpositioniereinrichtung eine Positionierplatte (9) ist.

8. Adapter nach Anspruch 7, **dadurch gekennzeichnet,**
**daß** die Positionierplatte (9) auf der von der Leiterplatte (2) abgewandten Seite der Nadelführungsplatte (6) angeordnet ist und zumindest einen Leiterplattenaufnahmestift (11) aufweist, der die Nadelführungsplatte (6) mit Spiel durchgreift und in eine Leiterplatte (2) ohne Spiel eingreifen kann.

9. Adapter nach Anspruch 1 oder 2, **dadurch gekennzeichnet,**
**daß** die Leiterplattenpositioniereinrichtung ein Leiterplattenpositionierrahmen ist, der auf der der Leiterplatte (2) zugewandten Seite der Nadelführungsplatte (6) angeordnet ist und eine auf der Nadelführungsplatte (6) auflegbare Leiterplatte (2) formschlüssig umfassen kann.

10. Prüfvorrichtung zum zweiseitigen Prüfen von Leiterplatten mit zwei gekoppelten Adaptern (1a, 1b), die jeweils ober- bzw. unterhalb der Leiterplatte (2) angeordnet sind, wobei zumindest einer der beiden Adapter (1a, 1b) gemäß einem der Ansprüche 1 bis 9 ausgebildet ist,
**dadurch gekennzeichnet,**
**daß** der eine erste Adapter (1a) eine zweite Verstelleinrichtung innerhalb des Adapterkörpers (3) und
ein Koppelelement (70) aufweist, das mit einem korrespondierenden Koppelelement (71) am zweiten Adapter (1b) einkoppeln kann, so dass beim Prüfen einer Leiterplatte (2) die Anordnung der beiden Adapter (1a, 1b) zueinander festgelegt ist, wobei die zweite Verstelleinrichtung zum Verschieben der Leiterplatte (2) gegenüber den Prüfnadeln (4) des zweiten Adapters (1b) dient.

11. Prüfvorrichtung nach Anspruch 10, **dadurch gekennzeichnet,**
**daß** der erste Adapter (1a) eine horizontale Befestigungsplatte (69) aufweist, die lagefixiert in den Adapter eingebaut ist und auf der eine Nadelführungsplatte (6) oder eine Positionierplatte (9) aufliegt, wobei ein erster Aktuator (16a) zum Verschieben der Nadelführungsplatte (6) oder der Positionierplatte (9) gegenüber der Befestigungsplatte (69) vorgesehen ist.

12. Prüfvorrichtung zum zweiseitigen Prüfen von Leiterplatten mit zwei Adaptern (1a, 1b), die jeweils ober- bzw. unterhalb der Leiterplatte (2) angeordnet sind, wobei beide Adapter (1a, 1b) gemäß einem der Ansprüche 1 bis 9 ausgebildet sind,
**dadurch gekennzeichnet,**
**daß** zumindest bei einem ersten der beiden Adapter (1a) die Leiterplattenpositioniereinrichtung auf der zur Leiterplatte (2) zeigenden Seite der Nadelführungsplatte (6) angeordnet ist.

13. Prüfvorrichtung nach Anspruch 12, **dadurch gekennzeichnet,**
**daß** beim zweiten der beiden Adapter (1b) die Nadelführungsplatte (6) benachbart zur Leiterplatte (2) angeordnet ist.

14. Prüfvorrichtung nach einem der Ansprüche 10 bis 13,
**dadurch gekennzeichnet,**
**daß** die beiden Adapter (1a, 1b) mit mindestens einem Fangstift (70, 76) und einer Buchse (71, 77) koppelbar ausgebildet sind.

## Claims

1. An adapter for testing printed circuit boards comprising an adapter body (3) and a plurality of test needles (4) traversing the adapter body (3),
two adjustment devices for adjusting the test needles (4) at test pads provided on the circuit board (2) by a relative movement of the circuit board (2) and the test needles (4), with one adjustment device having a needle guide plate (6) in which the ends of the test needles to be contacted with the test pads are supported in guide holes (7) that are arranged in the pattern of the test pads of the circuit board (2) to be tested,
the adjustment devices comprising a circuit board positioning device being configured to secure a circuit board (2) to be tested in a fixed position relative to the adapter (1),
wherein the needle guide plate (6) and the circuit board positioning device are arranged movable relative to each other such that the ends of the test needles (4) to be contacted with the test pads can be aligned with the test pads, and
wherein the adjustment devices are arranged within the adapter body (3), and wherein the circuit board positioning device comprises at least one plate-shaped region which overlaps the needle guide plate (6) wherein both the circuit board positioning device and the needle guide plate (6) comprise a plurality of holes in a predetermined pattern within the overlapping region, wherein a respective hole (21 b) of the circuit board positioning device is allocated a hole
(21 a) of the needle guide plate (6) and wherein the holes of these mutually allocated pairs of holes are spaced apart from each other each in a different direction and/or each with a different pitch with respect to a zero position corresponding to an ideal adjustment for a distortion-free circuit board (2) such that by insertion of a pin the two holes (21 a, 21 b) of a pair of holes are aligned with each other and the circuit board positioning device and the needle guide plate (6) are moved with respect to each other accordingly.

2. The adapter according to claim 1, **characterized in that**
the holes (21 a, 21 b) are each arranged in a square hole matrix (20) with the holes (21 a, 21 b) each having a constant hole pitch (a, b), wherein the hole pitch (a) of the holes of the needle guide board (6) is different from the hole pitch (b) of the circuit board positioning device by Δs.

3. The adapter according to claim 1 or 2, **characterized in that**
an actuator (16) is provided for moving the circuit board positioning device and the needle guide device (6) relative to each other which is a piezoelectric adjustment unit (30) comprising at least one piezoelectric element for mutual movement of the circuit board positioning device and the needle guide device (6).

4. The adapter according to claim 3, **characterized in that**
the piezoelectric adjustment unit (30) comprises two actuation members arranged rectangularly to each other.

5. The adapter according to claim 4, **characterized in that**
the actuation members (36, 37) each comprise two piezoelectric bars (42a, 42b) as piezoelectric elements, which are arranged in parallel to each other and are supplied with a voltage of opposite polarity such that when applying the voltage they pivot sideways with respect to their longitudinal extension.

6. The adapter according to claim 5, **characterized in that**
the actuation members (36, 37) each comprise a U-shaped pivoting frame (38, 45) with two legs (39, 46) and a base rack (40, 47) wherein the piezoelectric element bars (42a, 42b, 48a, 48b) are arranged in parallel with and between the legs (39, 46),
the piezoelectric element bars (42a, 42b, 48a, 48b) being each connected to the base rack (40, 47) via a pivoting element (43, 51), and
the free ends of the legs (39, 46) and of piezoelectric element bars (42a, 42b, 48a, 48b) are connected to a region of a support frame (31) or a bracket (54) terminating the U-shaped pivoting frames (38, 45) to become a rectangle such that when supplying the piezoelectric element bars (42a, 42b, 48a, 48b) with a voltage, the base racks (40, 47) are moved in parallel with respect to the region of the support frame (31) or bracket (54) in the manner of a parallel guide.

7. The adapter according to any preceding claim, **characterized in that** the circuit board positioning device is a positioning plate (9).

8. The adapter according to claim 7, **characterized in that** the positioning plate (9) is arranged on the side of the needle guide plate (6) facing away from the circuit board (2) and comprises at least one circuit board receiving pin (11) which traverses the needle guide plate (6) with a play and is operative to engage a circuit board (2) without play.

9. The adapter according to claim 1 or 2, **characterized in that**
the circuit board positioning device is a circuit board positioning frame arranged on the side of the needle guide plate (6) facing the circuit board (2) and may positively fitting include a circuit board (2) placeable onto the needle guide plate (6).

10. A Testing device for two-sided testing of circuit boards with two coupled adapters (1a, 1b) arranged above or beneath the circuit board (2), respectively, wherein at least one of the two adapters (1a, 1 b) is configured according to any of claims 1 to 9, **characterized in that**
the said first adapter (1 a) comprises a second adjustment device within the adapter body (3) and a coupling element (70) which is able to couple with a corresponding coupling element (71) at the second adapter (1 b) such that during testing of a circuit board (2) the arrangement of the two adapters (1a, 1 b) is fixed with respect to each other wherein the second adjustment device serves for moving the circuit board (2) with respect to the test needles (4) of the second adapter (1 b).

11. The testing device according to claim 10, **characterized in that**
said first adapter (1a) comprises a horizontal mounting plate (69) which is positioned within the adapter in a fixed orientation and on which is placed a needle guide plate (6) or a positioning plate (9) wherein a first actuator (16a) is provided for moving the needle guide plate (6) or the positioning plate (9) with respect to the mounting board (69).

12. The Testing device for two-sided testing of circuit boards with two adapters (1a, 1 b) arranged above or beneath the circuit board (2), respectively, with both adapters (1a, 1 b) being configured according to any of claims 1 to 9,
**characterized in that**
at least at the first one of the two adapters (1a) the circuit board positioning device is arranged on the side of the needle guide plate (6) facing the circuit board (2).

13. The testing device according to claim 12, **characterized in that**
at the second one of the two adapters (1 b) the needle guide plate (6) is arranged adjacent to the circuit board (2).

14. The testing device according to any of claims 10 to 13, **characterized in that** both adapters (1a, 1 b) are configured in a coupling relationship with at least one spring-loaded guide pin (70, 76) and a socket (71, 77).

## Revendications

1. Adaptateur pour tester des cartes à circuits imprimés électriques, comprenant un corps d'adaptateur (3) et un certain nombre d'aiguilles de test (4) qui traversent le corps d'adaptateur (3),
deux dispositifs de déplacement pour ajuster les aiguilles de test (4) vers les points de test prévus sur la carte à circuits imprimés (2) par une translation relative entre la carte à circuits imprimés (2) et les aiguilles de test (4), dans lequel un dispositif de déplacement comprend une plaque de guidage d'aiguilles (6) dans laquelle les extrémités des aiguilles de test destinées à venir en contact avec les points de test sont montées dans des perçages de guidage (7) qui sont agencés suivant le motif des points de test qu'il s'agit de tester sur la carte à circuits imprimés (2),
dans lequel les dispositifs de déplacement présentent un moyen de positionnement de carte à circuits imprimés qui est capable de fixer une carte à circuits imprimés (2) à tester dans une position fixe par rapport à l'adaptateur (1),
dans lequel la plaque de guidage d'aiguilles (7) et le moyen de positionnement de cartes à circuits imprimés sont agencés avec possibilité de translation l'un par rapport à l'autre, de sorte que les extrémités des aiguilles de test (4) qui doivent être mises en contact avec les points de test peuvent être orientées vers les points de test, et
dans lequel les dispositifs de déplacement sont agencés à l'intérieur du corps d'adaptateur (3),
et le moyen de positionnement de cartes à circuits imprimés comprend au moins une zone en forme de plaque qui est en chevauchement avec la plaque de guidage d'aiguilles (6), de sorte que dans la zone en chevauchement sont ménagés un certain nombre de trous, aussi bien dans le moyen de positionnement de carte à circuits imprimés que dans la plaque de guidage d'aiguilles (6), et cela dans un motif prédéterminé, de façon qu'à un trou respectif (2 b) du moyen de positionnement de cartes à circuit imprimé est associé à un trou (21 a) de la plaque de guidage d'aiguilles (6), et les trous de ces paires de trous mutuellement associés sont écartés l'un de l'autre respectivement en direction différente et/ou à distance différente par rapport à une position zéro, qui correspond à un ajustement idéal pour une carte à circuits imprimés (2) sans déformation, de sorte que par enfichage d'une tige, les deux trous (21 a, 21 b) d'une paire de trous sont orientés en alignement l'un par rapport à l'autre, et le moyen de positionnement de cartes à circuit imprimé et la plaque de guidage d'aiguilles (6) sont déplacés en correspondance l'un par rapport à l'autre.

2. Adaptateur selon la revendication 1,
**caractérisé en ce que** les trous (21a, 21 b) sont agencés respectivement dans une matrice de trous (20) carrée, dans laquelle les trous (21 a, 21 b) présentent chacun un écartement constant (a, b), et l'écartement (a) des trous de la plaque de guidage d'aiguilles (6) diffère de l'écartement (b) des trous du moyen de positionnement de carte à circuits imprimés à raison d'une valeur □s.

3. Adaptateur selon la revendication 1 ou 2,
**caractérisé en ce qu'**il est prévu un actionneur (16) pour déplacer le moyen de positionnement de carte à circuits imprimés et la plaque de guidage d'aiguilles (6) l'un par rapport à l'autre, cet actionneur étant une unité de déplacement piézo-électiiqüe (30) qui comprend au moins un élément piézo-électrique pour le déplacement mutuel du moyen de positionnement de carte à circuits imprimés et de la plaque de guidage d'aiguilles (6).

4. Adaptateur selon la revendication 3,
**caractérisé en ce que** l'unité de déplacement piézo-électrique (30) comprend deux organes de positionnement agencés à angle droit l'un par rapport à l'autre.

5. Adaptateur selon la revendication 4,
**caractérisé en ce que** les organes de positionnement (36, 37) comprennent chacun deux tiges piézo-électriques (42a, 42b), en guise d'éléments piézo-électriques, qui sont agencées parallèlement l'une à l'autre, et qui sont excitées par une tension à polarité opposée, de sorte que lors de l'application de la tension, elles pivotent latéralement par rapport à leur extension longitudinale.

6. Adaptateur selon la revendication 5,
**caractérisé en ce que** les organes de positionnement (36, 37) comprennent chacun un cadre pivotant (38, 45) en forme de U avec deux branches (39, 46) et une âme de base (40,47), les tiges (42a, 42b, 48a, 48b) des éléments piézo-électriques étant agencées parallèlement aux branches (39, 46) et entre celles-ci,
les tiges (42a, 42b, 48a, 48b) des éléments piézo-électriques sont reliées chacune à l'âme de base (40, 47) au moyen d'un élément pivotant (43, 51), et
les extrémités libres des branches (39, 46) et des tiges (42a, 42b, 48a, 48b) des éléments piézo-électriques sont reliées à une zone d'un cadre porteur (31) ou d'un étrier (54), qui referme le cadre pivotant en forme de U (38, 45) pour former un rectangle, de sorte que par excitation des tiges (42a, 42b, 48a, 48b) des éléments piézo-électriques avec une tension, les âmes de base (40, 47) sont déplacées parallèlement à la zone du cadre porteur (31) ou de l'étrier (54) à la manière d'une tringlerie à parallélogramme.

7. Adaptateur selon l'une ou les revendications précédentes,
**caractérisé en ce que** le moyen de positionnement de carte à circuits imprimés est une plaque de positionnement (9).

8. Adaptateur selon la revendication 7,
**caractérisé en ce que** la plaque de positionnement (9) est agencée sur le côté, détourné de la carte à circuits imprimés (2), de la plaque de guidage d'aiguilles (6) et comprend au moins un ergot de réception (11) pour carte à circuits imprimés, qui traverse avec jeu la plaque de guidage d'aiguilles (6) et peut s'engager sans jeu dans une carte à circuits imprimés (2).

9. Adaptateur selon la revendication 1 ou 2,
**caractérisé en ce que** le moyen de positionnement de carte à circuits imprimés est un cadre de positionnement de carte à circuits imprimés, lequel est agencé sur le côté, détourné de la carte à circuits imprimés (2), de la plaque de guidage d'aiguilles (6), et peut entourer par coopération de formes une carte à circuits imprimés (2) susceptible d'être posée sur la plaque de guidage d'aiguilles (6).

10. Dispositif de test pour tester sur deux côtés des cartes à circuits imprimés, comprenant deux adaptateurs couplés (1a, 1 b) qui sont agencés respectivement au-dessus et au-dessous de la carte à circuits imprimés (2), l'un au moins des deux adaptateurs (1a, 1b) étant réalisé selon l'une des revendications 1 à 9,
**caractérisé en ce que**
un premier adaptateur (1a) comprend un second dispositif de déplacement à l'intérieur du corps d'adaptateur (3) et un élément de couplage (70) qui est susceptible de s'accoupler avec un élément de couplage correspondant (71) sur le second adaptateur (1 b), de sorte que lors du test d'une carte à circuits imprimés (2) l'agencement des deux adaptateurs (1a, 1 b) l'un par rapport à l'autre est déterminé, et le second dispositif de déplacement sert à déplacer la carte à circuits imprimés (2) par rapport aux aiguilles de test (4) du second adaptateur (1b).

11. Dispositif de test selon la revendication 10,
**caractérisé en ce que** le premier adaptateur (1a) comprend une plaque de fixation horizontale (69) qui est intégrée en position fixe dans l'adaptateur et sur laquelle est posée une plaque de guidage d'aiguilles (6) ou une plaque de positionnement (9), et **en ce qu'**il est prévu un premier actionneur (16a) pour déplacer la plaque de guidage d'aiguilles (6) ou la plaque de positionnement (9) par rapport à la plaque de fixation (69).

12. Dispositif de test pour tester sur deux côtés des cartes à circuits imprimés, comprenant deux adaptateurs (1a, 1b) qui sont agencés respectivement au-dessus et au-dessous de la carte à circuits imprimés (2), les deux adaptateurs (1a, 1 b) étant réalisés selon l'une des revendications 1 à 9,
**caractérisé en ce que**
au moins dans un premier des deux adaptateurs (1a), le moyen de positionnement de cartes à circuit imprimé est agencé sur le côté de la plaque de guidage d'aiguilles (6) qui est tourné vers la carte à circuits imprimés (2).

13. Dispositif de test selon la revendication 12,
**caractérisé en ce que**, dans le second des deux adaptateurs (1 b), la plaque de guidage d'aiguilles (6) est agencée au voisinage de la carte à circuits imprimés (2).

14. Dispositif de test selon l'une des revendications 10 à 13,
**caractérisé en ce que** les deux adaptateurs (1a, 1 b) sont réalisés de façon à pouvoir être accouplés avec au moins un ergot de prise (70, 76) et une douille (71 , 77).
